# EUROPÄISCHE PATENTSCHRIFT

(11) **EP 3 422 576 B1**
(45) Veröffentlichungstag und Bekanntmachung des Hinweises auf die Patenterteilung: **20.03.2024**
(21) Anmeldenummer: 18180275.2
(22) Anmeldetag: 28.06.2018
(51) Int. Cl.: H03K 17/687, H01L 29/40, H01L 29/732, H01L 29/78, H01L 29/808, H01L 29/94, H01L 27/07, H01L 29/08, H01L 29/74, H02M 1/32, H02M 1/34

(54) **ELEKTRISCHE SCHALTUNGSANORDNUNG MIT EINER AKTIVEN ENTLADESCHALTUNG**
ELECTRIC CIRCUIT ASSEMBLY HAVING ACTIVE DISCHARGE CIRCUIT
AGENCEMENT DE CIRCUIT ÉLECTRIQUE DOTÉ D'UN CIRCUIT DE DÉCHARGE ACTIF

(30) Priorität: 29.06.2017 DE 102017211030
(43) Veröffentlichungstag der Anmeldung: 02.01.2019
(73) Patentinhaber: Fraunhofer-Gesellschaft zur Förderung der angewandten Forschung e.V., 80686 München (DE)
(72) Erfinder: Erlbacher, Tobias, 91099 Poxdorf (DE); Matlok, Stefan, 91058 Erlangen (DE)
(74) Vertreter: Gagel, Roland

(56) Entgegenhaltungen:
- DE-A1-102006 017 487
- DE-A1-102009 030 965
- US-A1- 2006 044 846
- VOM DORP J ET AL: "Monolithic RC-snubber for power electronic applications", POWER ELECTRONICS AND DRIVE SYSTEMS (PEDS), 2011 IEEE NINTH INTERNATIONAL CONFERENCE ON, IEEE, 5. Dezember 2011 (2011-12-05), Seiten 11-14, XP032112322, DOI: 10.1109/PEDS.2011.6147217 ISBN: 978-1-61284-999-7

## Beschreibung

### Technisches Anwendungsgebiet

Die vorliegende Erfindung betrifft eine elektrische Schaltungsanordnung mit einer aktiven Entladeschaltung, die wenigstens ein elektrisches Schaltelement aufweist, über das die Schaltungsanordnung gesteuert entladen werden kann.

Zur elektrischen Kopplung unterschiedlicher elektrischer Netze werden Zwischenkreise eingesetzt, die die Netze auf einer zwischengeschalteten Strom- oder Spannungsebene über Umrichter elektrisch koppeln. Bei Anwendungen in der Kraftfahrzeugtechnik muss ein derartiger Zwischenkreis aus Sicherheitsgründen im Falle einer Störung oder eines Unfalls in kurzer Zeit entladen werden. So existieren Sicherheitsanforderungen, nach denen der Zwischenkreis eines Gerätes im Antriebsstrang eines Kraftfahrzeugs innerhalb von 5 Sekunden auf unter 60 V entladen werden muss. Für diese Entladung ist eine aktive Entladeschaltung erforderlich, über die der Zwischenkreis bei Bedarf gesteuert entladen werden kann.

### Stand der Technik

Aus O. Kreutzer et al., "A simple, reliable, cost and volume saving DC-link discharge device for electric vehicles", ITEC 2015, DOI: 10.1109/ITEC.2015.7165800, ist eine Schaltungsanordnung mit einer aktiven Entladeschaltung bekannt, die wenigstens ein elektrisches Schaltelement aufweist, über das die Schaltungsanordnung, ein Zwischenkreis, gesteuert entladen werden kann. Eine derartige Entladeschaltung kostet jedoch entsprechend Platz, muss entwärmt werden und sicher isoliert sein.

Bei Schaltkreisen der Leistungselektronik ist es bekannt, RC-Snubberglieder zur Dämpfung von Spannungs- oder Stromspitzen im Schaltkreis einzusetzen, die durch Schaltvorgänge im Schaltkreis ausgelöst werden. Ein derartiges RC-Snubberglied stellt eine Reihenschaltung aus einem Kondensator und einem Widerstand dar. Aus J. vom Dorp et al., "Monolithic RC-Snubber for Power Electronic Applications", IEEE PEDS 2011, Seiten 11 bis 14, ist eine monolithisch integrierte Ausführung eines derartigen RC-Snubberglieds bekannt. Bei dieser Ausgestaltung sind in einem Silizium-Substrat zylinderförmige Vertiefungen ausgebildet, die mit einer elektrisch isolierenden, Siliziumnitrit beinhaltenden dielektrischen Schichtfolge beschichtet und mit hochdotiertem Polysilizium aufgefüllt sind. Das Silizium-Substrat ist zwischen der dielektrischen Schichtfolge und der Rückseite durch hohe Dotierung elektrisch leitfähig ausgebildet. Es trägt auf der Vorderseite und der Rückseite jeweils eine Kontaktmetallisierung. Durch diese Ausgestaltung werden eine hohe Kapazität des Kondensators auf kleinem Raum und eine sehr gute Entwärmbarkeit erreicht.

Aus der US 2010/0163950 A1 ist ebenfalls eine Halbleiterstruktur mit einem integrierten RC-Snubberglied bekannt, bei dem der schaltende Leistungstransistor, dessen Spannungs- bzw. Stromspitzen durch das RC-Snubberglied gedämpft werden sollen, benachbart zum RC-Snubberglied in das Halbleitersubstrat integriert ist.

Die US 2006/044846 A1 beschreibt eine Anordnung zur unterbrechungsfreien Stromversorgung mit einer Schaltung, die einen Kondensator zwischen zwei Leitungen eines DC-Busses aus Sicherheitsgründen entladen soll, wenn die unterbrechungsfreie Spannungsversorgung abgeschaltet wird. Die Schaltung umfasst zwischen den beiden Leitungen eine passive Entladeschaltung aus zwei Widerständen in Reihe zu einem Schalter, der von einer Kontrollschaltung gesteuert wird. Der Schalter setzt sich aus einem Transistor und einem dazu parallelen Kondensator zusammen.

Die Aufgabe der vorliegenden Erfindung besteht darin, eine elektrische Schaltungsanordnung mit einer aktiven Entladeschaltung anzugeben, bei der die Entladeschaltung kostengünstig und platzsparend in die Schaltungsanordnung integriert ist.

### Darstellung der Erfindung

Die Aufgabe wird mit der elektrischen Schaltungsanordnung gemäß Patentanspruch 1 gelöst. Vorteilhafte Ausgestaltungen der Schaltungsanordnung sind Gegenstand der abhängigen Patentansprüche oder lassen sich der nachfolgenden Beschreibung sowie den Ausführungsbeispielen entnehmen.

Bei der vorgeschlagenen elektrischen Schaltungsanordnung weist die Entladeschaltung wenigstens ein elektrisches Schaltelement auf, über das die Schaltungsanordnung, insbesondere ein Zwischenkreis, gesteuert entladen werden kann. Die Schaltungsanordnung zeichnet sich dadurch aus, dass sie ein RC-Snubberglied mit Kondensator und Widerstand zur Dämpfung von Spannungs- oder Stromspitzen in der Schaltungsanordnung aufweist und das elektrische Schaltelement parallel zum Kondensator des RC-Snubberglieds verschaltet in das RC-Snubberglied integriert ist.

Durch diese Integration des wenigstens einen elektrischen Schaltelementes der aktiven Entladeschaltung in das RC-Snubberglied wird eine platz- und kostensparende Ausgestaltung der Entladeschaltung ermöglicht. Durch die Integration entfällt eine zusätzliche Kontaktierung. Das Snubberglied ist genau für die Leistungsklasse ausgebildet, in der auch die Entladung arbeiten muss. Dies ist bei Anwendungen in der Kraftfahrzeugtechnik derzeit ein Bereich zwischen ca. 5 W und 100 W. Eine externe Anordnung der Entladeschaltung ist immer mit zusätzlichen Kosten und zusätzlichem Platzbedarf verbunden und stellt auch ein Isolationsproblem dar. Das in der Schaltungsanordnung vorhandene RC-Snubberglied hat bereits ein passendes Isolations- und Entwärmungskonzept, das dann auch für die Entladeschaltung zur Verfügung steht. Das Snubberglied mit integriertem Schaltelement ist nicht gleichzeitig mit Entladen und Bedämpfen beschäftigt, sondern führt nur eine Funktion zur einer Zeit aus. Damit wird auch das thermische System zur Entwärmung optimal genutzt.

Der Kondensator und der Widerstand des RC-Snubberglieds sind zusammen mit dem wenigstens einen elektrischen Schaltelement monolithisch in ein Halbleitersubstrat integriert. Damit wird eine sehr gute Entwärmung beider Teilkomponenten ermöglicht, indem das Halbleitersubstrat bspw. auf einem geeigneten Metallkörper aufgebracht wird. Ein Beispiel hierfür ist ein sog. DCB-Substrat (DCB: Direct Copper Bonded).

Das Halbleitersubstrat ist zur Bildung des RC-Snubberglieds auf der Vorderseite mit einer Anordnung von vorzugsweise Via-artigen oder zylinderförmigen Vertiefungen versehen, die mit einer elektrisch isolierenden dielektrischen Schicht oder Schichtfolge beschichtet und mit einem elektrisch leitfähigen Material aufgefüllt sind. Das Halbleitersubstrat ist dabei im Bereich der Vertiefungen zwischen der Vorderseite und der Rückseite durch eine Dotierung elektrisch leitfähig ausgebildet und trägt auf der Vorderseite und der Rückseite jeweils eine Kontaktmetallisierung. Hierbei kann eine Ausgestaltung gewählt werden, wie sie bspw. in der eingangs genannten Veröffentlichung von J. vom Dorp et al. beschrieben ist. Das elektrisch leitfähige Material und das dotierte Halbleitersubstrat mit der zwischenliegenden dielektrischen Schicht oder Schichtfolge bilden hierbei den Kondensator und der Bereich zwischen der dielektrischen Schicht oder Schichtfolge und der Rückseite des Substrats den Widerstand des RC-Snubberglieds. Mehrere der elektrischen Schaltelemente der Entladeschaltung sind hierbei zwischen den Vertiefungen und/oder um die Anordnung von Vertiefungen herum verteilt ausgebildet, um bei entsprechender Ansteuerung den Kondensator bzw. die dielektrische Schicht oder Schichtfolge des Kondensators elektrisch zu überbrücken. Eine derartige Realisierung kann auch als separates elektrisches Bauteil bereitgestellt werden.

Die elektrischen Schaltelemente können bspw. als MOSFETs, JFETs, Bipolartransistoren oder auch als Thyristoren ausgebildet sein. Die Ansteuerung kann über eine geeignete Spannung, einen geeigneten Strom oder über einen Lichtleiter in Verbindung mit einem Optokoppler erfolgen. Die Dimensionierung des Schaltelementes bzw. der Schaltelemente kann derart erfolgen, dass ein gewünschter Entladestrom z.B. im Sättigungsbetrieb realisiert werden kann. Die hohe Entwärmbarkeit des Schaltelementes bleibt dabei erhalten, weil die thermischen Verluste im Halbleitersubstrat entstehen und dort gut abgeführt werden können. So ist bspw. eine Entwärmbarkeit von 250 W/cm² über DCB möglich. Für einen Zwischenkreiskondensator von 100 µF und einer Spannung von 800 V ist z.B. ein (idealer) Entladestrom von ca. 15 mA nötig um den Kondensator auf unter 60V zu entladen. Das führt zu einer Spitzenverlustleistung von ca. 11 bis 13,3 Watt (bei 900 V dauerhaft anliegender Überspannung im Fehlerfall). Mit einer Chipfläche von ca. 5 mm² wäre die Schaltung somit dauerlastfest. Leistungshalbleiterbauelemente haben demgegenüber bei entsprechender Spannungsfestigkeit und Chipfläche einen Durchlasswiderstand von typischerweise < 1 Ω und würden beim normalen Einschalten sofort thermisch zerstört werden.

In der bevorzugten Ausgestaltung wird für das elektrische Schaltelement eine Normally-on-Struktur oder -Schaltung mit einer Selbstversorgung aus der Schaltungsanordnung gewählt. Die Ansteuerung des Schaltelementes erfolgt dabei vorzugsweise über nur einen separaten Anschluss bzw. Pin.

Die vorgeschlagene Schaltungsanordnung sowie das vorgeschlagene elektrische Bauteil lassen sich in allen Anwendungen einsetzen, bei denen eine gesteuerte Entladung eines Schaltkreises realisiert werden soll. Dies betrifft bspw. Leistungsmodule oder PCB/DCBbasierte leistungselektronische Systeme, insbesondere in einer Realisierung als Zwischenkreis.

### Kurze Beschreibung der Zeichnungen

Die vorgeschlagene Schaltungsanordnung und das vorgeschlagene elektrische Bauteil werden nachfolgend anhand von Ausführungsbeispielen in Verbindung mit den Zeichnungen nochmals beispielhaft näher erläutert. Hierbei zeigen:
- Fig. 1: ein beispielhaftes Schaltbild der vorgeschlagenen Schaltungsanordnung;
- Fig. 2: eine vereinfachte Darstellung des Schaltbildes eines RC-Snubberglieds mit dem parallel geschalteten Schaltungselement für die nachfolgenden Darstellungen;
- Fig. 3: ein erstes Beispiel für eine Realisierung des RC-Snubberglieds mit integriertem Schaltelement in Querschnittdarstellung;
- Fig. 4: ein zweites Beispiel für eine Realisierung des RC-Snubberglieds mit integriertem Schaltelement in Querschnittdarstellung;
- Fig. 5: ein drittes Beispiel für eine Realisierung des RC-Snubberglieds mit integriertem Schaltelement in Querschnittdarstellung;
- Fig. 6: ein viertes Beispiel für eine Realisierung des RC-Snubberglieds mit integriertem Schaltelement in Querschnittdarstellung;
- Fig. 7: ein fünftes Beispiel für eine Realisierung des RC-Snubberglieds mit integriertem Schaltelement in Querschnittdarstellung; und
- Fig. 8: ein weiteres Beispiel für eine Schaltungsanordnung, die das RC-Snubberglied mit dem integrierten Schaltelement zeigt.

### Wege zur Ausführung der Erfindung

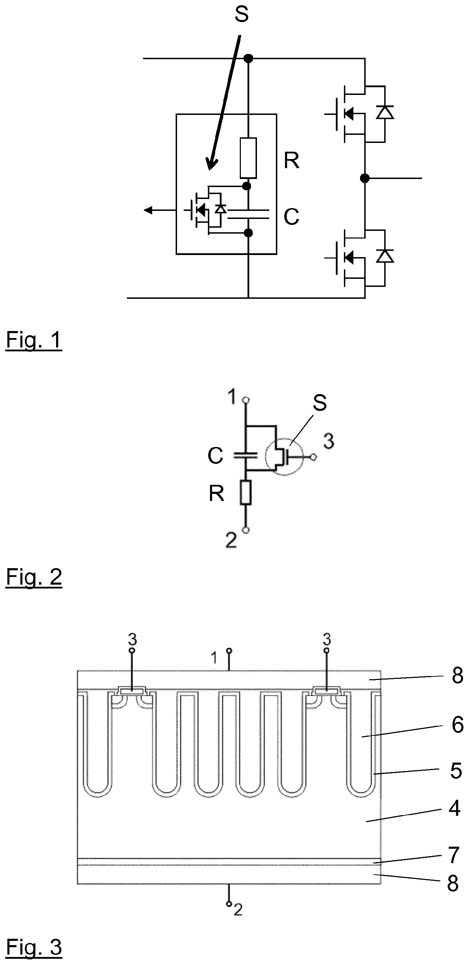

Bei der vorgeschlagenen Schaltungsanordnung wird ein RC-Snubberglied mit mehreren integrierten Schaltelementen eingesetzt, über die die Schaltungsanordnung entladen werden kann. Figur 1 zeigt hierzu einen Teil eines Zwischenkreises mit entsprechenden Schaltern, in dem die durch das Schalten entstehenden Spannungs- und/oder Stromspitzen durch ein RC-Snubberglied gedämpft werden, das in der Figur eingerahmt dargestellt ist. In dieses RC-Snubberglied ist parallel zum Kondensator C ein Schaltelement S integriert. Durch geeignete Ansteuerung dieses Schaltelementes S, im vorliegenden Beispiel ein MOSFET mit parallel geschalteter Sperrdiode, kann der Kondensator C des Snubberglieds elektrisch überbrückt und damit der Zwischenkreis in kurzer Zeit entladen werden. In der bevorzugten Ausgestaltung ist das RC-Snubberglied zusammen mit dem Schaltelement S monolithisch in einem Halbleitersubstrat integriert. Im Folgenden werden einige Beispiele für eine Realisierung eines derartigen RC-Snubberglieds mit monolithisch integriertem Schaltelement angeführt. Figur 2 zeigt hierzu stark schematisiert zunächst ein Schaltbild eines RC-Snubberglieds mit dem integrierten Schaltelement S, den elektrischen Anschlüssen 1, 2 des Snubberglieds sowie dem Ansteueranschluss 3 des Schalters S.

Figur 3 zeigt hierbei ein Beispiel für eine Bauelementstruktur, bei dem das Snubberglied mit einem normally-on MOSFET realisiert wird. In diesem Beispiel wird ein Si-Halbleitersubstrat 4 einer ausreichend hohen Dotierung mit Via-artigen Vertiefungen versehen. In diese Vertiefungen sowie auf die Oberfläche des Substrates wird eine dielektrische Schicht oder Schichtfolge 5 aufgebracht. Die Vertiefungen werden anschließend mit einem elektrisch leitfähigen Material 6 wie z.B. hochdotiertem Polysilizium verfüllt. An der rückseitigen Oberfläche des Halbleitersubstrats 4 erfolgt eine nochmals höhere Dotierung, um eine elektrische Kontaktschicht 7 für einen ohmschen Kontakt zu bilden. Auf die Vorder- und Rückseite des Substrats 4 wird anschließend eine Metallschicht 8 aufgebracht, die zur Kontaktierung des RC-Snubberglieds über die elektrischen Anschlüsse 1, 2 dient. Der dotierte Bereich des Halbleitersubstrats 4 zwischen der vorderseitigen und der rückseitigen Oberfläche stellt gleichzeitig den Widerstand R des Snubberglieds dar. Die dielektrische Schicht 5 bildet zusammen mit den benachbarten elektrisch leitfähigen Bereichen (elektrisch leitfähige Füllung 6, elektrisch leitfähiges Halbleitersubstrat 4) den Kondensator C des Snubberglieds. Dies ist in allen nachfolgenden Ausgestaltungen in gleicher Weise realisiert. Die Anzahl und Dimensionierung der einzelnen Vertiefungen wird in Abhängigkeit vom gewünschten Wert des Kondensators C gewählt. Hierzu wird beispielhaft auf die in der Beschreibungseinleitung angeführte Veröffentlichung von J. vom Dorp et al. verwiesen.

Bei der vorgeschlagenen Schaltungsanordnung werden nun bei einer derartigen Ausgestaltung des RC-Snubberglieds mehrere Schaltelemente S zwischen den einzelnen Vertiefungen ausgebildet und entsprechend über die Fläche des RC-Snubberglieds verteilt. Die Figuren 3 bis 7 zeigen hierbei beispielhaft zwei dieser Schaltelemente S. Im Beispiel der Figur 3 wird die Schaltungsanordnung mit einem normally-on MOSFET realisiert. Dies erfordert gegenüber dem üblichen Herstellungsprozess eines derartigen Snubberglieds zusätzliche Maskenebenen für die Wanne, den Kontakt für den Ansteueranschluss 3, das Gateoxid sowie für Feldoxid/Isolation.

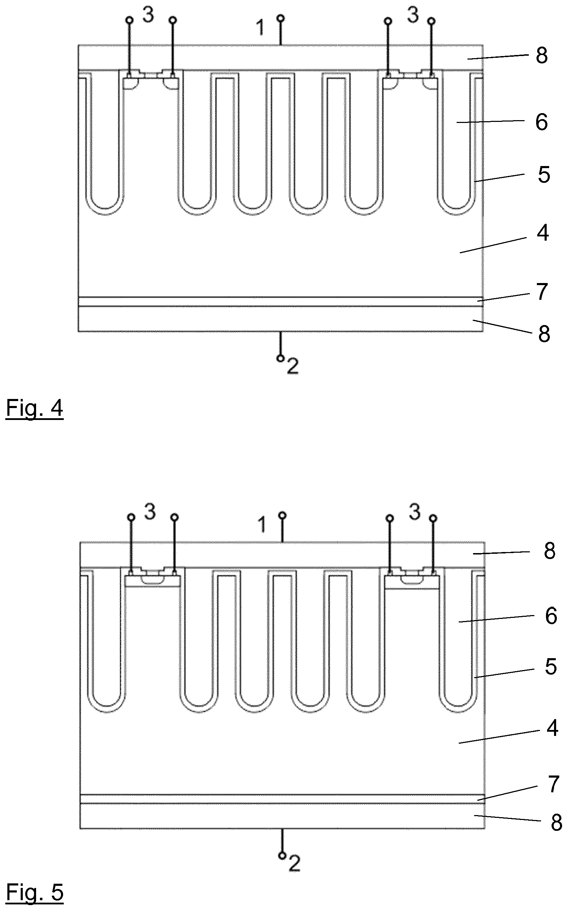

Anstelle eines MOSFET kann auch ein JFET eingesetzt werden, der lediglich zusätzliche Maskenebenen für die Wanne, den Kontakt und für Feldoxid/Isolation erfordert. Allerdings benötigt der JFET im Vergleich zum MOSFET eine negative Ansteuerspannung. Eine derartige Ausgestaltung der Bauelementstruktur ist beispielhaft in Figur 4 für einen normally-on JFET dargestellt.

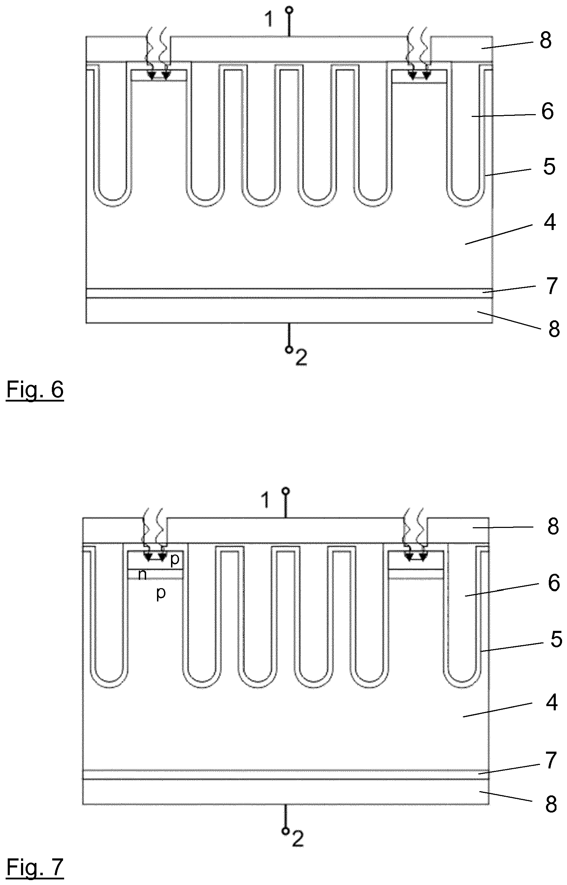

Die vorgeschlagene Schaltungsanordnung lässt sich auch mit einem Bipolartransistor als Schaltelement realisieren, wie dies in den Figuren 5 und 6 schematisch dargestellt ist. Ein pnp-Bipolartransistor erfordert zusätzliche Maskenebenen für die N-Basis, den P-Emitter und für Feldoxid/Isolation. Figur 5 zeigt hierzu ein Beispiel für einen Bauelementstruktur mit zwei elektrisch angesteuerten pnp-Bipolartransistoren. Figur 6 zeigt die Bauelementstruktur mit zwei optisch eingeschalteten Bipolartransistoren. Die einfallende optische Strahlung und die hierfür erforderlichen Öffnungen in der oberen Metallisierung 8 sind in der Figur 6 angedeutet.

Die Schaltungsanordnung lässt sich auch mit einem Thyristor realisieren, der zusätzliche Maskenebenen für die N-Basis, die P-Basis und den N-Emitter sowie für Feldoxid/Isolation erfordert. Figur 7 zeigt hierzu beispielhaft eine Bauelementstruktur mit zwei optisch gezündeten Thyristoren.

Die Schaltung kann prinzipiell in unterschiedlicher Weise realisiert werden. So kann in einer beispielhaften Ausgestaltung eine deutliche natürliche Abhängigkeit von der Temperatur genutzt werden. Bei steigender Temperatur soll auch der Entladestrom des Schaltelementes sinken. Damit kann die Schaltung eigensicherer gestaltet werden. ist die Verlustleistung pro mm² entsprechend gering, beispielsweise unter 1 W/mm² bei höchster Spannung, so wird das Snubberglied mit der Entladeschaltung sicher vor Überlast betreibbar sein, solange eine ausreichend große thermische Masse und/oder alternative Wärmeleitpfade z.B. über die Bodenplatte vorhanden sind.

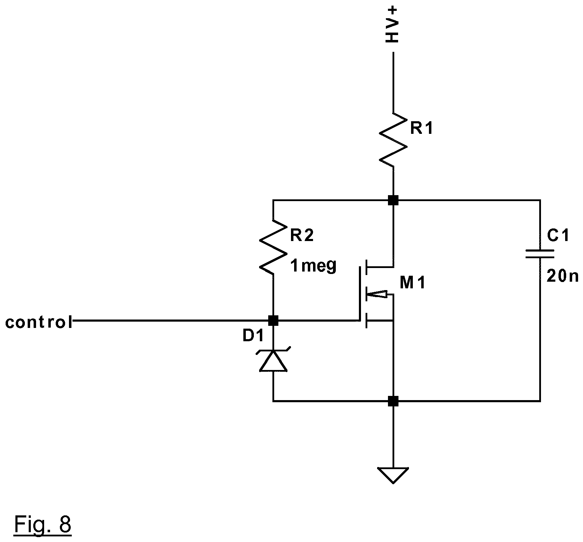

In einer anderen Ausgestaltung kann die Schaltung so ausgelegt werden - oder es können auch zusätzliche Elemente eingesetzt werden -, um eine extreme Temperaturabhängigkeit im aktiven Zustand zu realisieren. Idealerweise ergibt sich dadurch eine Ecktemperatur. Darüber ist die Entladeschaltung sehr hochohmig, darunter sehr niederohmig. Das jeweilige Schaltelement ist in dieser Ausgestaltung somit als leistungsbegrenzendes Schaltelement ausgebildet, bei dem sich ein Temperaturanstieg oberhalb der Ecktemperatur durch den starken Abfall des Entladestroms des Schaltelementes selbst begrenzt. Damit ließe sich eine durchgehende inhärente Eigensicherheit vor Überlast erreichen. Ein maximal schnelles Entladen ist dann auch bei deutlich geringeren Einsatzspannungen möglich. Ein derartiges Element ist dann bspw. für 400 V Systeme genauso einsetzbar wie für 800 V usw. Figur 8 zeigt ein Schaltungsbeispiel für ein derartiges RC-Snubberglied mit dem Widerstand R1, dem Kondensator C1, dem Schalter M1 sowie parallel zum Schalter einer Reihenschaltung aus einer Diode D1 und weiterem Widerstand R2. Die Verluste bei der Entladung entstehen dabei in erster Linie im Schalter M1 und nicht im Widerstand R1 des Snubberglieds.

Eine Deaktivierung der Entladefunktion kann über einen externen Optokoppler erfolgen, so dass nur ein einziger Pin zur Ansteuerung des Schaltelementes M1 nötig ist.

Mit der vorgeschlagenen Schaltungsanordnung lässt sich die Entladung eines Schaltkreises, insbesondere eines Zwischenkreises, über einen kleinen, eigensicheren Leistungsschalter verteilt über die große Chipfläche eines RC-Snubberglieds realisieren. Die Schaltungsanordnung ist eigensicher und dauerkurzschlussfest. Die Entladegeschwindigkeit ist über die Partitionierung beeinflussbar.

### Bezugszeichenliste

- 1: oberer Anschluss für RC-Snubberglied
- 2: unterer Anschluss für RC-Snubberglied
- 3: Steueranschluss für Schaltelement
- 4: Halbleitersubstrat
- 5: dielektrische Schicht bzw. Schichtfolge
- 6: elektrisch leitfähige Füllung
- 7: ohmsche Schicht
- 8: Metallisierungsschicht
- R: Widerstand des RC-Snubberglieds
- C: Kondensator des RC-Snubberglieds
- S: elektrisches Schaltelement

## Patentansprüche

1. Elektrische Schaltungsanordnung mit einer aktiven Entladeschaltung, die wenigstens ein elektrisches Schaltelement (S) aufweist, über das die Schaltungsanordnung gesteuert entladen werden kann,
- wobei die Schaltungsanordnung ein RC-Snubberglied mit Kondensator (C) und Widerstand (R) zur Dämpfung von Spannungs- oder Stromspitzen in der Schaltungsanordnung aufweist und das wenigstens eine elektrische Schaltelement (S) parallel zum Kondensator (C) des RC-Snubberglieds in das RC-Snubberglied integriert und so ausgebildet und verschaltet ist, dass es den Kondensator des RC-Snubberglieds zur Entladung der Schaltungsanordnung überbrückt, **dadurch gekennzeichnet, dass**
- der Kondensator (C) und der Widerstand (R) des RC-Snubberglieds zusammen mit dem wenigstens einen elektrischen Schaltelement (S) monolithisch in ein Halbleitersubstrat (4) integriert sind, dass
- das Halbleitersubstrat (4) zur Bildung des RC-Snubberglieds auf einer Vorderseite eine Anordnung von Vertiefungen aufweist, die mit einer elektrisch isolierenden dielektrischen Schicht oder Schichtfolge (5) beschichtet und mit einem elektrisch leitfähigen Material (6) aufgefüllt sind, dass
- das Halbleitersubstrat (4) zumindest im Bereich der Vertiefungen zwischen der Vorderseite und einer Rückseite durch eine Dotierung elektrisch leitfähig ausgebildet ist und auf der Vorderseite und der Rückseite jeweils eine Kontaktmetallisierung (8) trägt, und dass
- mehrere der elektrischen Schaltelemente (S) zwischen den Vertiefungen verteilt und/oder um die Anordnung der Vertiefungen herum im Halbleitersubstrat (4) ausgebildet sind.

2. Elektrische Schaltungsanordnung nach Anspruch 1, **dadurch gekennzeichnet,**
**dass** das wenigstens eine elektrische Schaltelement (S) als MOSFET, JFET, Bipolartransistor oder als Thyristor ausgebildet ist.

3. Elektrische Schaltungsanordnung nach Anspruch 1 oder 2,
**dadurch gekennzeichnet,**
**dass** das wenigstens eine elektrische Schaltelement (S) so ausgebildet ist, dass es über ein elektrisches oder über ein optisches Steuersignal zur Entladung der Schaltungsanordnung ansteuerbar ist.

4. Elektrische Schaltungsanordnung nach einem der Ansprüche 1 bis 3,
**dadurch gekennzeichnet,**
**dass** das wenigstens eine elektrische Schaltelement (S) als leistungsbegrenzendes Schaltelement ausgebildet ist, bei dem sich ein Temperaturanstieg oberhalb einer Ecktemperatur durch einen Abfall des Entladestroms des Schaltelementes (S) selbst begrenzt.

5. Elektrische Schaltungsanordnung nach einem der Ansprüche 1 bis 4,
**dadurch gekennzeichnet,**
**dass** die Schaltungsanordnung als Zwischenkreis ausgebildet ist.

## Claims

1. An electric circuit assembly having an active discharge circuit which includes at least one electrical switching element (S), via which the circuit assembly can be discharged in controlled manner,
- wherein the circuit assembly includes a RC snubber element with capacitor (C) and resistor (R) for damping voltage or current peaks in the circuit assembly, and the at least one electrical switching element (S) is integrated in the RC snubber element in parallel to the capacitor (C) of the RC snubber element and is designed and connected in such manner that it bypasses the capacitor of the RC snubber element to discharge the circuit assembly,
**characterized in that**
- the capacitor (C) and the resistor (R) of the RC snubber element are integrated monolithically in a semiconductor substrate (4) together with the at least one electrical switching element (S), that
- a front side of the semiconductor substrate (4) has an arrangement of recesses which are coated with an electrically isolating dielectric layer or layer sequence (5) and filled with an electrically conductive material (6) to form the RC snubber element, that
- the semiconductor substrate (4) is designed to be electrically conductive by doping at least in the region of the recesses between the front side and a back side, and has a contact metallisation (8) on each of the front side and the back side, and that
- a plurality of the electrical switching elements (S) are distributed between the recesses and/or are formed around the arrangement of recesses in the semiconductor substrate (4).

2. The electric circuit assembly according to Claim 1, **characterized in that**
the at least one electrical switching element (S) is embodied as a MOSFET, JFET, bipolar transistor or a thyristor.

3. The electric circuit assembly according to Claim 1 or 2,
**characterized in that**
the at least one electrical switching element (S) is designed such that it can be actuated via an electrical or an optical control signal to discharge the circuit assembly.

4. The electric circuit assembly according to any one of Claims 1 to 3,
**characterized in that**
the at least one electrical switching element (S) is designed as a power-limiting switching element, in which a temperature rise above a threshold temperature limits itself by a fall in the discharge current of the switching element (S).

5. The electric circuit assembly according to any one of Claims 1 to 4,
**characterized in that**
the circuit assembly is designed as an intermediate circuit.

## Revendications

1. Agencement de circuit électrique doté d'une circuit de décharge actif, qui présente au moins un élément de commutation électrique (S), par l'intermédiaire duquel l'agencement de circuit peut être déchargé de manière commandée,
- dans lequel l'agencement de circuit présente un organe d'amortisseur RC avec un condensateur (C) et une résistance (R) pour atténuer les pics de tension ou de courant et qui intègre au moins un élément de commutation électrique (S) parallèlement au condensateur (C) de l'organe d'amortisseur RC et est configuré et câblé de telle sorte qu'il enjambe le condensateur de l'organe d'amortisseur RC pour décharger l'agencement de circuit,
**caractérisé en ce que**
- le condensateur (C) et la résistance (R) de l'organe d'amortisseur RC sont intégrés conjointement à au moins un élément de commutation électrique (S) de manière monolithique dans un substrat semi-conducteur (4),
- le substrat semi-conducteur (4) présente pour former l'organe d'amortisseur RC sur un côté avant un agencement de cavités, qui sont revêtues d'une couche ou d'une séquence de couches (5) diélectriques électriquement isolantes et sont remplies avec un matériau électriquement conducteur (6),
- le substrat semi-conducteur (4) est configuré de manière électriquement conductrice par un dopage au moins au niveau des cavités entre le côté avant et un côté arrière et supporte sur le côté avant et le côté arrière respectivement une métallisation de contact (8), et
- plusieurs des éléments de commutation électriques (S) sont répartis entre les cavités et/ou autour de l'agencement des cavités dans le substrat semi-conducteur (4).

2. Agencement de circuit électrique selon la revendication 1, **caractérisé en ce que** au moins un élément de commutation électrique (S) est configuré comme un MOSFET, JFET, transistor bipolaire ou thyristor.

3. Agencement de circuit électrique selon la revendication 1 ou 2, **caractérisé en ce que** au moins un élément de commutation électrique (S) est configuré de telle sorte qu'il puisse être commandé par l'intermédiaire d'un signal de commande électrique ou optique pour décharger l'agencement de circuit.

4. Agencement de circuit électrique selon une des revendications 1 à 3, **caractérisé en ce que** au moins un élément de commutation électrique (S) est configuré comme un élément de commutation limiteur de puissance, dans lequel une hausse de température se limite elle-même au-dessus d'une température d'angle du fait d'une chute du courant de décharge de l'élément de commutation (S).

5. Agencement de circuit électrique selon une des revendications 1 à 4, **caractérisé en ce que** l'agencement de circuit est conçu comme un circuit intermédiaire.
